# EUROPÄISCHE PATENTSCHRIFT

(11) **EP 3 961 158 B1**
(45) Veröffentlichungstag und Bekanntmachung des Hinweises auf die Patenterteilung: **23.11.2022**
(21) Anmeldenummer: 20192523.7
(22) Anmeldetag: 25.08.2020
(51) Int. Cl.: G01D 5/20

(54) **ABTASTELEMENT UND INDUKTIVE POSITIONSMESSEINRICHTUNG MIT DIESEM ABTASTELEMENT**
SCANNING UNIT AND INDUCTIVE POSITION MEASURING DEVICE WITH SUCH A SCANNING UNIT
UNITÉ DE BALAYAGE ET DISPOSITIF INDUCTIF DE MESURE DE POSITION POURVU D'UNE TELLE UNITÉ DE BALAYAGE

(43) Veröffentlichungstag der Anmeldung: 02.03.2022
(73) Patentinhaber: Dr. Johannes Heidenhain GmbH, 83301 Traunreut (DE)
(72) Erfinder: HEINEMANN, Christoph, 83236 Übersee (DE); TIEMANN, Marc Oliver, 83329 Waging am See (DE)

(56) Entgegenhaltungen:
- WO-A1-2019/185336
- DE-A1-102014 201 975
- FR-A1- 2 800 457

## Beschreibung

### GEBIET DER TECHNIK

Die Erfindung betrifft ein Abtastelement für eine induktive Positionsmesseinrichtung gemäß dem Anspruch 1 zur Positionsbestimmung des Abtastelements relativ zu zwei mit unterschiedlicher Geschwindigkeit bewegbaren Skalenelementen.

Induktive Positionsmesseinrichtungen werden beispielsweise als Winkelmessgeräte zur Bestimmung der Winkelposition von relativ zueinander drehbaren Maschinenteilen verwendet. Bei induktiven Positionsmesseinrichtungen sind häufig Erregerleitungen und Empfängerspuren etwa in Form von Leiterbahnen auf einer gemeinsamen meist mehrlagigen Leiterplatte aufgebracht, die beispielsweise mit einem Stator eines Winkelmessgeräts fest verbunden ist. Dieser Leiterplatte gegenüber befindet sich ein Skalenelement, auf dem Teilungsstrukturen aufgebracht sind, und welches mit dem Rotor des Winkelmessgeräts drehfest verbunden ist. Wenn an den Erregerleitungen ein zeitlich wechselnder elektrischer Erregerstrom angelegt wird, werden in den Empfängerspulen während der Relativdrehung zwischen Rotor und Stator von der Winkelposition abhängige Signale erzeugt. Diese Signale werden dann in einer Auswerteelektronik weiterverarbeitet.

Insbesondere werden bei Antrieben von Robotern häufig induktive Positionsmesseinrichtungen als Messgeräte für die Bestimmung der Winkellage einer Antriebswelle und gleichzeitig für die exakte Bestimmung der Winkellage einer Abtriebswelle eingesetzt, wobei die Bewegung der Antriebswelle durch ein Untersetzungsgetriebe in die Abtriebswelle eingeleitet wird. In diesem Fall werden Winkelpositionen beziehungsweise Winkelstellungen mithilfe eines Abtastelements gemessen, welches eine Leiterplatte umfasst, die an beiden Seiten entsprechende Detektoreinheiten aufweist, so dass die jeweilige Winkelstellung von beidseitig der Leiterplatte drehbar angeordneten Skalenelementen bestimmt werden kann.

Induktive Positionsmesseinrichtungen werden auch als Längenmessgeräte zur Bestimmung der Position zweier relativ zueinander insbesondere linear verschiebbarer Maschinenteile verwendet. Auch bei dieser Anwendung kann das erfindungsgemäße Abtastelement mit an beiden Seiten angeordneten Detektoreinheiten verwendet werden.

### STAND DER TECHNIK

In der WO 2019/185336 A1 wird ein Abtastelement mit einer Sendespule und Sensorspulen beschrieben, die auf einer mehrlagigen Leiterplatte angeordnet sind, wobei die Leiterplatte Lagen aufweist, die als Abschirmung ausgebildet sind.

Das Dokument FR 2 800 457 A1 beschreibt ein ähnliches Abtastelement, wobei die mehrlagige Leiterplatte zusätzlich elektronische Bauteile umfasst.

### ZUSAMMENFASSUNG DER ERFINDUNG

Der Erfindung liegt die Aufgabe zugrunde ein vergleichsweise genau arbeitendes und kostengünstig herstellbares Abtastelement für eine induktive Positionsmesseinrichtung zu schaffen, durch welches eine Bestimmung von Positionen zweier Skalenelemente ermöglicht ist.

Diese Aufgabe wird erfindungsgemäß durch die Merkmale des Anspruches 1 gelöst.

Das Abtastelement, welches für eine induktive Positionsmesseinrichtung geeignet und bestimmt ist, umfasst eine mehrlagige Leiterplatte mit einer ersten

Detektoreinheit und mit einer zweiten Detektoreinheit sowie elektronische Bauteile. Insbesondere ist die erste Detektoreinheit an einer ersten Seite der Leiterplatte angeordnet und die zweite Detektoreinheit an einer zweiten Seite der Leiterplatte. Die erste Detektoreinheit weist eine erste Erregerspur und eine erste Empfängerspur auf. Die zweite Detektoreinheit weist eine zweite Erregerspur und eine zweite Empfängerspur auf. Außerdem weist die Leiterplatte eine erste Abschirmschicht sowie eine zweite Abschirmschicht und eine geometrische Mittenebene auf, die insbesondere mittig zwischen der ersten Seite und der zweiten Seite der Leiterplatte angeordnet ist, wobei die Mittenebene jeweils zwischen den Detektoreinheiten und zwischen den Abschirmschichten zu liegen kommt. Weiterhin ist die mehrlagige Leiterplatte so aufgebaut, dass in einer ersten Lage und in einer zweiten Lage die erste Detektoreinheit angeordnet ist und zudem in einer dritten Lage und in einer vierten Lage die zweite Detektoreinheit. Die Abschirmschichten sind so dimensioniert beziehungsweise bemessen, dass eine gedachte geometrische erste Gerade sowohl die erste Detektoreinheit als auch die erste Abschirmschicht durchdringt beziehungsweise schneidet, während die zweite Abschirmschicht nicht von der ersten Geraden durchdrungen wird. Dabei ist ausgehend von der ersten Detektoreinheit die erste Abschirmschicht jenseits der Mittenebene angeordnet. Ferner durchdringt beziehungsweise schneidet eine gedachte geometrische zweite Gerade sowohl die zweite Detektoreinheit als auch die zweite Abschirmschicht, während die erste Abschirmschicht nicht von der zweiten Geraden durchdrungen wird. Die zweite Abschirmschicht ist ausgehend von der zweiten Detektoreinheit jenseits der Mittenebene angeordnet. Die erste Gerade und die zweite Gerade sind orthogonal zur Mittenebene orientiert.

Die erste Gerade kann die erste Detektoreinheit im Bereich der ersten Erregerspur oder im Bereich der ersten Empfängerspur schneiden beziehungsweise durchdringen. Die zweite Gerade kann die zweite Detektoreinheit im Bereich der zweiten Erregerspur oder im Bereich der zweiten Empfängerspur schneiden beziehungsweise durchdringen. Die erste Erregerspur und die zweite Erregerspur umfassen Erregerleiterbahnen, welche in unterschiedlichen Lagen (nämlich in der ersten, zweiten, dritten und vierten Lage) der Leiterplatte verlaufen. Ebenso umfassen die erste Empfängerspur und die zweite Empfängerspur Empfängerleiterbahnen, die in der ersten, zweiten, dritten und vierten Lage der Leiterplatte verlaufen.

Im Hinblick auf eine Festlegung der räumlichem Anordnung des Erfindungsgegenstandes kann zunächst eine erste Richtung x definiert werden. Die erste Richtung x stellt diejenige Richtung dar, in welcher die gesuchte Position gemessen wird (Messrichtung). Die erste Richtung x kann beispielsweise eine Umfangsrichtung beziehungsweise eine Tangentialrichtung sein. In diesem Fall kann eine Winkelstellung des Skalenelements relativ zum Abtastelement bezogen auf eine Dreh- oder Schwenkbewegung um eine (Dreh- Achse) durch die Positionsmessung in der ersten Richtung gemessen werden. Im Falle einer linearen Positionsmessung verläuft die erste Richtung x entlang der linearen Messstrecke.

Zudem kann eine zweite Richtung y definiert werden, die orthogonal zur ersten Richtung x verläuft.

Orthogonal zur ersten Richtung x und gleichzeitig orthogonal zur zweiten Richtung y ist eine dritte Richtung z orientiert. Beispielsweise kann die dritte Richtung z parallel zur (Dreh-) Achse, um welche ein Skalenelement relativ zum Abtastelement drehbar ist, verlaufen. Zudem ist die dritte Richtung z orthogonal zur Mittenebene ausgerichtet. Die einzelnen Lagen der Leiterplatte sind in der dritten Richtung z zueinander versetzt angeordnet.

Die Mittenebene kommt bezogen auf die dritte Richtung z zwischen der ersten Detektoreinheit und der ersten Abschirmschicht zu liegen beziehungsweise die erste Detektoreinheit und die erste Abschirmschicht sind beidseits der Mittenebene angeordnet. Folglich gilt ebenso, dass die Mittenebene bezogen auf die dritte Richtung z zwischen der zweiten Detektoreinheit und der zweiten Abschirmschicht zu liegen kommt beziehungsweise gilt, dass die zweite Detektoreinheit und die zweite Abschirmschicht beidseits der Mittenebene angeordnet sind.

Mit Vorteil sind die erste Abschirmschicht in einer fünften Lage der Leiterplatte und die zweite Abschirmschicht in einer sechsten Lage der Leiterplatte angeordnet. Alternativ können die erste Abschirmschicht in der ersten Lage oder in der zweiten Lage und die zweite Abschirmschicht in der dritten Lage oder in der vierten Lage angeordnet sein.

In weiterer Ausgestaltung der Erfindung verlaufen die erste Erregerspur und die zweite Erregerspur entlang der ersten Richtung x. In der zweiten Richtung y ist die erste Abschirmschicht mit einem ersten Abstand versetzt gegenüber der zweiten Erregerspur angeordnet. Alternativ oder ergänzend ist die zweite Abschirmschicht mit einem zweiten Abstand in der zweiten Richtung versetzt gegenüber der ersten Erregerspur angeordnet.

In vorteilhafter Weise ist in der dritten Richtung, die orthogonal zur Mittenebene orientiert ist, die erste Detektoreinheit mit einer Distanz versetzt gegenüber der ersten Abschirmschicht angeordnet, wobei der zweite Abstand größer oder gleich 25% der Distanz und kleiner oder gleich 100% der Distanz ist. Alternativ oder ergänzend ist die zweite Detektoreinheit mit einer Distanz versetzt gegenüber der zweiten Abschirmschicht angeordnet, wobei der erste Abstand größer oder gleich 25% der Distanz und kleiner oder gleich 100% der Distanz ist. Vorzugsweise ist der zweite Abstand größer oder gleich 33% der Distanz und kleiner oder gleich 75% der Distanz und / oder der erste Abstand größer oder gleich 33% der Distanz und kleiner oder gleich 75% der Distanz.

Mit Vorteil verlaufen die erste Empfängerspur und die zweite Empfängerspur entlang der ersten Richtung x. Die erste Empfängerspur ist in der zweiten Richtung y mit einem Versatz gegenüber der zweiten Empfängerspur angeordnet.

In weiterer Ausgestaltung der Erfindung ist das Abtastelement so ausgebildet, dass die erste Gerade oder die zweite Gerade zumindest eines der elektronischen Bauteile durchdringt. Alternativ können die erste Gerade und die zweite Gerade ein oder mehrere elektronischen Bauteile durchdringen, insbesondere dann, wenn die Leiterplatte an beiden Seiten mit elektronischen Bauteilen bestückt ist.

In vorteilhafter Weise ist die Leiterplatte so aufgebaut, dass die erste Gerade die erste Empfängerspur der ersten Detektoreinheit und / oder die zweite Gerade die zweite Empfängerspur der zweiten Detektoreinheit durchdringt.

Mit Vorteil verlaufen die erste Erregerspur und die zweite Erregerspur entlang der ersten Richtung x, wobei die erste Erregerspur relativ zur zweiten Erregerspur auf der Leiterplatte überlappend bezogen auf die zweite Richtung y angeordnet ist. Mit anderen Worten überlappen sich die Bereiche der ersten Erregerspur und der zweiten Erregerspur in der zweiten Richtung y. Insbesondere kann die Überlappung nahezu 100% betragen, so dass die erste Erregerspur relativ zur zweiten Erregerspur praktisch ohne Versatz in der zweiten Richtung y angeordnet ist.

In weiterer Ausgestaltung der Erfindung weist die erste Detektoreinheit eine dritte Erregerspur und die zweite Detektoreinheit eine vierte Erregerspur auf. Die dritte Erregerspur ist in der zweiten Richtung mit einem Versatz gegenüber der vierten Erregerspur angeordnet.

In vorteilhafter Weise ist das Abtastelement so ausgestaltet, dass die erste Erregerspur und die zweite Erregerspur elektrisch in Serie geschaltet sind.

Mit Vorteil sind die erste Erregerspur und die zweite Erregerspur mit einem Erregerstrom bestrombar, welcher üblicherweise eine zeitlich wechselnde Stromstärke aufweist (Wechselstrom oder Mischstrom). Der Erregerstrom ist mit Hilfe der elektronischen Bauteile generierbar, das heißt, dass dessen Verlauf von den elektronischen Bauteilen formbar ist. Nachdem ein physikalischer Zusammenhang zwischen der Stromstärke und der Spannungsstärke existiert, kann natürlich die gleiche Betrachtung auch für die Erregerspannung vorgenommen werden.

In weiterer Ausgestaltung der Erfindung sind diejenigen Signale, die von der ersten Empfängerspur und der zweiten Empfängerspur erzeugbar sind, mit Hilfe der elektronischen Bauteile, die insbesondere eine Auswerteschaltung bilden weiterverarbeitbar.

Die elektronischen Bauteile können also Elemente verschiedener elektronischer Schaltungen sein beziehungsweise unterschiedlichen Schaltungen zugeordnet sein. Beispielsweise können bestimmte elektronische Bauteile Elemente der Schaltung zur Generierung eines Erregerstroms sein oder weitere elektronische Bauteile können Elemente einer weiteren Schaltung zur Auswertung beziehungsweise Weiterverarbeitung von Signalen sein.

Gemäß einem weiteren Aspekt umfasst die Erfindung auch eine induktive Positionsmesseinrichtung mit dem Abtastelement sowie einem ersten Skalenelement und einem zweiten Skalenelement. Die Skalenelemente sind in der dritten Richtung z (orthogonal zur Mittenebene) beabstandet, beidseits der Leiterplatte angeordnet. Weiterhin können die Skalenelemente um eine gemeinsame Achse relativ zum Abtastelement drehbar angeordnet sein.

Vorteilhafte Ausbildungen der Erfindung entnimmt man den abhängigen Ansprüchen.

Weitere Einzelheiten und Vorteile des erfindungsgemäßen Abtastelements ergeben sich aus der nachfolgenden Beschreibung mehrerer Ausführungsbeispiele anhand der beiliegenden Figuren.

### KURZE BESCHREIBUNG DER ZEICHNUNGEN

- Figur 1: eine perspektivische Ansicht einer Positionsmesseinrichtung umfassend ein Abtastelement und ein erstes Skalenelement sowie ein zweites Skalenelement,
- Figur 2: eine Draufsicht auf eine erste Seite des Abtastelements,
- Figur 3: eine Draufsicht auf eine zweite Seite des Abtastelements
- Figur 4: ein Detailschnitt durch das Abtastelement gemäß einem ersten Ausführungsbeispiel
- Figur 5: eine Draufsicht auf ein erstes Skalenelement
- Figur 6: eine Draufsicht auf ein zweites Skalenelement,
- Figur 7: ein Detailschnitt durch das Abtastelement gemäß einem zweiten Ausführungsbeispiel.

### BESCHREIBUNG DER AUSFÜHRUNGSFORMEN

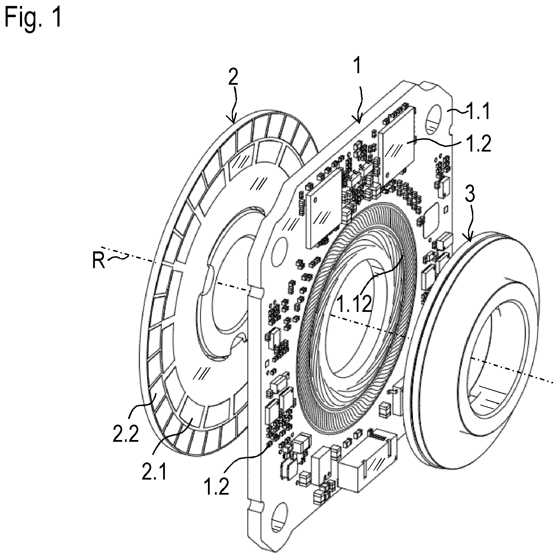

Die Erfindung wird gemäß der Figur 1 anhand einer Positionsmesseinrichtung beschrieben, welche ein Abtastelement 1 aufweist, das sowohl zur Erfassung einer Winkelstellung eines ersten Skalenelements 2 als auch einer Winkelstellung eines zweiten Skalenelements 3 verwendet werden kann. Beide Skalenelemente 2, 3 sind um eine Achse R relativ zum Abtastelement 1 drehbar angeordnet. Eine derartige Positionsmesseinrichtung kann beispielsweise in einer Antriebseinrichtung eines Roboters verwendet werden. Das zweite Skalenelement 3 ist dann etwa mit einer Antriebswelle eines Motors drehfest verbunden. Diese ist wiederum mit einem Untersetzungsgetriebe verbunden, welches eine Abtriebswelle aufweist. Mit dieser Abtriebswelle dreht sich das erste Skalenelement 2. Auf diese Weise kann beispielsweise eine Winkelstellung zur Kommutierung des Motors mit Hilfe des zweiten Skalenelements 3 und eine vergleichsweise hochgenaue Winkelstellung zur Positionierung des Roboters mit Hilfe des ersten Skalenelements 2 durchgeführt werden.

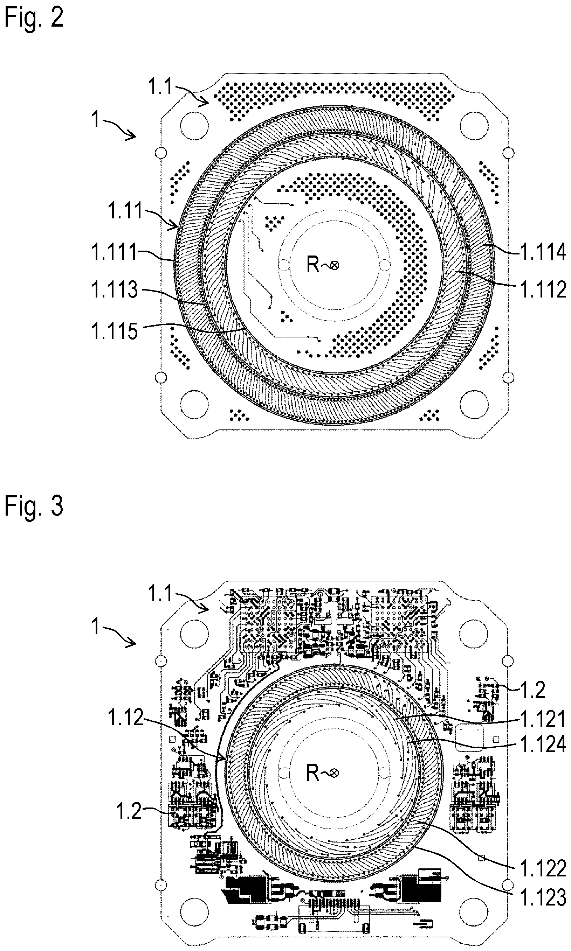

Das Abtastelement 1, welches in den Figuren 2 und 3 jeweils in einer Draufsicht dargestellt ist, umfasst eine Leiterplatte 1.1, welche mehrere Lagen aufweist, sowie elektronische Bauteile 1.2 (Figur 3), die auf der Leiterplatte 1.1 montiert sind. Das Abtastelement 1 dient zur Abtastung des ersten Skalenelements 2 und gleichzeitig zur Abtastung des zweiten Skalenelements 3. Aus diesem Grund sind auf einer ersten Seite der Leiterplatte 1.1 gemäß der Figur 2 eine erste Detektoreinheit 1.11 und auf einer zweiten Seite der Leiterplatte 1.1 gemäß der Figur 3 eine zweite Detektoreinheit 1.12 angeordnet. Im vorgestellten Ausführungsbeispiel sind elektronische Bauteile 1.2 nur auf der zweiten Seite montiert. Alternativ oder ergänzend könnte aber auch die erste Seite der Leiterplatte 1.1 mit elektronischen Bauteilen bestückt werden.

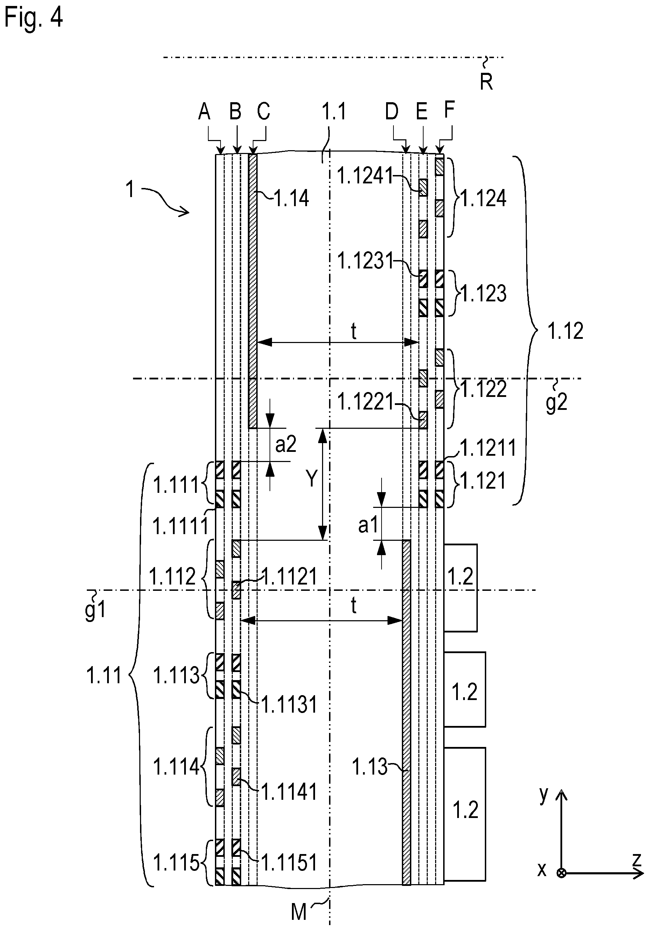

Die erste Detektoreinheit 1.11 umfasst eine erste Erregerspur 1.111, eine erste Empfängerspur 1.112, eine dritte Erregerspur 1.113, eine dritte Empfängerspur 1.114 und eine fünfte Erregerspur 1.115. Die zweite Detektoreinheit 1.12 umfasst eine zweite Erregerspur 1.121, eine zweite Empfängerspur 1.122, eine vierte Erregerspur 1.123 und eine vierte Empfängerspur 1.124. In der Figur 4 ist eine schematische Teilschnittdarstellung durch das Abtastelement 1 beziehungsweise der Leiterplatte 1.1 gezeigt, wobei der Übersichtlichkeit halber auf eine Schraffur von elektrisch isolierendem Material der Leiterplatte 1.1 verzichtet wurde. Zudem ist die Teilschnittdarstellung der Figur 4 zur besseren Erläuterbarkeit des erfindungsgemäßen Abtastelements 1 nicht maßstabsgetreu ausgeführt. Die Leiterplatte 1.1 ist, wie oben bereits erwähnt, mehrlagig aufgebaut. Geometrisch betrachtet kann für die Leiterplatte 1.1 eine so genannte Mittenebene M definiert werden, die parallel zur ersten Seite beziehungsweise parallel zur zweiten Seite der Leiterplatte 1.1 mittig zwischen der ersten und zweiten Seite angeordnet ist. Zudem können die geometrischen Beziehungen der einzelnen Elemente zueinander mit Hilfe eines Koordinatensystems definiert werden. Dabei ist eine erste Richtung x diejenige Richtung, entlang welcher bestimmungsgemäß eine Positions- beziehungsweise Winkelmessung erfolgen soll. Im vorgestellten Ausführungsbeispiel entspricht die erste Richtung x der Umfangsrichtung. Die Achse R, um welche die Skalenelemente 2, 3 drehbar sind, verläuft parallel zu einer dritten Richtung z, die dritte Richtung z kann demnach hier auch als axiale Richtung definiert werden. Orthogonal zur dritten Richtung z und zur ersten Richtung x ist eine zweite Richtung y orientiert, die im vorgestellten Ausführungsbeispiel (Winkelmessung) auch als radiale Richtung bezeichnet werden kann. Somit ist eine Ebene, die von der x- und y-Achse aufgespannt wird, parallel zur Mittenebene M orientiert und die dritte Richtung z sowie die Achse R verlaufen orthogonal zur Mittenebene M.

In einer ersten Lage A der Leiterplatte 1.1 und in einer zweiten Lage B der Leiterplatte 1.1 ist die erste Detektoreinheit 1.11 angeordnet, während in einer dritten Lage E und in einer vierten Lage F die zweite Detektoreinheit 1.12 angeordnet ist. Die erste Lage A ist der ersten Seite der Leiterplatte 1.1 am nächsten gelegen und die zweite Lage B ist der ersten Seite der Leiterplatte 1.1 am zweit-nächsten gelegen. Gleiches gilt für die dritte Lage E und die vierte Lage F bezüglich der zweiten Seite der Leiterplatte 1.1.

Die Erregerspuren 1.111, 1.113, 1.115 der ersten Detektoreinheit 1.11 umfassen Erregerleiterbahnen 1.1111, 1.1131, 1.1151, die in der ersten Lage A und in der zweiten Lage B verlaufen. Analog hierzu umfassen die Erregerspuren 1.121, 1.123 der zweiten Detektoreinheit 1.12 Erregerleiterbahnen 1.1231, 1.1231, die in der dritten Lage E und in der vierten Lage F verlaufen.

Die Erregerspuren 1.111, 1.113, 1.115 der ersten Detektoreinheit 1.11 umschließen die erste Empfängerspur 1.112 beziehungsweise die dritte Empfängerspur 1.114. Die zweite Erregerspur 1.121 und die vierte Erregerspur 1.123 der zweiten Detektoreinheit 1.12 umschließen die zweite Empfängerspur 1.122 der zweiten Detektoreinheit 1.12. Die vierte Empfängerspur 1.124, die ebenfalls der zweiten Detektoreinheit 1.12. zuzuordnen ist, wird einseitig von der vierten Erregerspur 1.123 umschlossen. Sowohl die Erregerspuren 1.111, 1.121, 1.113, 1.115, 1.121, 1.123 als auch die Empfängerspuren 1.112, 1.114, 1.122, 1.124 verlaufen entlang der ersten Richtung x.

Jede der Empfängerspuren 1.112, 1.114, 1.122, 1.124 umfasst jeweils mindestens zwei Empfängerleiterbahnen 1.1121, 1.1141, 1.1221, 1.1241. Zudem verlaufen die Empfängerleiterbahnen 1.1121, 1.1141 der ersten Detektoreinheit 1.11 mit Durchkontaktierungen in unterschiedlichen Lagen der Leiterplatte 1.1, nämlich in der ersten Lage A und in der zweiten Lage B, so dass an Kreuzungspunkten unerwünschte Kurzschlüsse vermieden werden. Das Gleiche gilt auch für die Empfängerleiterbahnen 1.1221, 1.1241 der zweiten Detektoreinheit 1.12, wobei diese in der dritten Lage E und in der vierten Lage F verlaufen. Die Empfängerleiterbahnen 1.1121, 1.1141, 1.1221, 1.1241 weisen einen räumlich periodischen Verlauf auf, der im Wesentlichen sinusförmig beziehungsweise sinusartig ausgestaltet ist. Im vorgestellten Ausführungsbeispiel sind diejenigen Empfängerleiterbahnen 1.1121, 1.1141, 1.1221, 1.1241, die sich in ein und derselben Empfängerspur 1.112, 1.114, 1.122, 1.124 befinden, um 1/4 der vollen Sinusperiode (um π/2 oder 90° entlang der ersten Richtung x) zueinander versetzt angeordnet. Die Empfängerleiterbahnen 1.1121, 1.1141, 1.1221, 1.1241 sind elektrisch so verschaltet, dass diese letztlich bezüglich der Positionsbestimmung in der ersten Richtung x um 90° phasenversetzte Signale liefern können.

Im vorgestellten Ausführungsbeispiel umfasst die Leiterplatte 1.1 auch eine fünfte Lage C und eine sechste Lage D. In der sechsten Lage D befindet sich eine erste Abschirmschicht 1.13 und in der fünften Lage C eine zweite Abschirmschicht 1.14. Die Abschirmschichten 1.13, 1.14 sind hier vergleichsweise großflächige Kupferschichten, die partiell unterbrochen sind beziehungsweise partiell entfernt worden sind.

Die erste Abschirmschicht 1.13 ist so dimensioniert, dass eine erste Gerade g1 erzeugbar ist, die orthogonal zur Mittenebene M und parallel zur dritten Richtung z orientiert ist, die sowohl die erste Detektoreinheit 1.11 als auch die erste Abschirmschicht 1.13 schneidet beziehungsweise durchdringt. Zudem durchdringt die erste Gerade g1 auch ein elektronisches Bauteil 1.2. Gleichzeitig wird aber die zweite Abschirmschicht 1.14 nicht von der ersten Geraden g1 durchdrungen. Zudem ist ausgehend von der ersten Detektoreinheit 1.11 die erste Abschirmschicht 1.13 jenseits der Mittenebene M angeordnet, also aus Sicht der ersten Detektoreinheit 1.11 auf der anderen Seite der Mittenebene M.

Außerdem ist die zweite Abschirmschicht 1.14 so dimensioniert, dass eine zweite Gerade g2 erzeugbar ist, die orthogonal zur Mittenebene M orientiert ist, sowohl die zweite Detektoreinheit 1.12 als auch die zweite Abschirmschicht 1.14 durchdringt. Die erste Abschirmschicht 1.13 wird nicht von der zweiten Geraden g2 durchdrungen. Ausgehend von der zweiten Detektoreinheit 1.12 ist die zweite Abschirmschicht 1.14 jenseits der Mittenebene M angeordnet.

Insbesondere ist die Leiterplatte 1.1 so aufgebaut, dass die erste Gerade g1 die erste Empfängerspur 1.112 der ersten Detektoreinheit 1.11 und die zweite Gerade g2 die zweite Empfängerspur 1.122 der zweiten Detektoreinheit 1.12 durchdringt.

Durch die beschriebene Anordnung liegt die erste Abschirmschicht 1.13 mit einer Distanz t bezogen auf die dritte Richtung z hinter der ersten Detektoreinheit 1.11 (beziehungsweise in der dritten Richtung z versetzt zur ersten Detektoreinheit 1.11). Dabei ist die Distanz t größer als die halbe Dicke der Leiterplatte 1. Gleiches gilt für die relative Anordnung der zweiten Abschirmschicht 1.14 relativ zur zweiten Detektoreinheit 1.12. Im vorgestellten Ausführungsbeispiel beträgt die Distanz t 2 mm, wobei sich die Distanz in der dritten Richtung z erstreckt.

Die erste Empfängerspur 1.112 ist in der zweiten Richtung y mit einem Versatz Y gegenüber der zweiten Empfängerspur 1.122 angeordnet. Dagegen weist die erste Erregerspur 1.111 in der zweiten Richtung y keinerlei Versatz zur zweiten Erregerspur 1.121 im vorgestellten Ausführungsbeispiel auf, so dass also die erste Erregerspur 1.111 relativ zur zweiten Erregerspur 1.121 auf der Leiterplatte 1.1 ohne Versatz in der zweiten Richtung y angeordnet ist.

Die erste Abschirmschicht 1.13 reicht bezogen auf die zweite Richtung y nicht an die zweite Erregerspur 1.121 heran, sondern es liegt ein (radialer) erster Abstand a1 in der zweiten Richtung y zwischen der ersten Abschirmschicht 1.13 und der zweiten Erregerspur 1.121 vor. Ebenso liegt ein zweiter Abstand a2 in der zweiten Richtung y zwischen der zweiten Abschirmschicht 1.14 und der ersten Erregerspur 1.111 vor. Folglich ist die erste Abschirmschicht 1.13 mit dem ersten Abstand a1 versetzt gegenüber der zweiten Erregerspur 1.121 angeordnet und zudem ist die zweite Abschirmschicht 1.14 mit dem zweiten Abstand a2 versetzt gegenüber der ersten Erregerspur 1.111 angeordnet. Es hat sich gezeigt, dass eine hohe Qualität der Messsignale und damit eine hohe Messgenauigkeit insgesamt erreichbar ist, wenn der erste Abstand a1 und / oder der zweite Abstand a2 einen Wert zwischen einschließlich 25%·t und 100%·t annimmt (0,25·t ≤ a1 ≤ 1·t; 0,25·t ≤ a2 ≤ 1·t). Im vorgestellten Ausführungsbeispiel gilt a1 = a2.

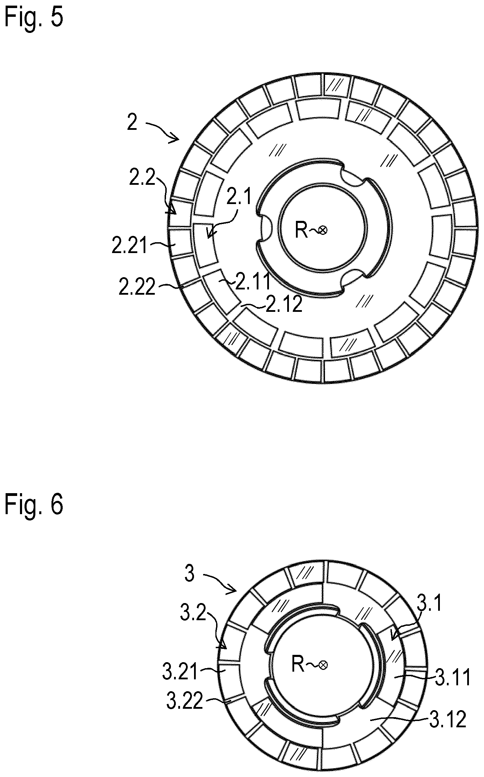

In der Figur 5 ist das erste Skalenelement 2 in einer Draufsicht gezeigt. Das zweite Skalenelement 3 ist in der Figur 6 ebenfalls in einer Draufsicht gezeigt. Die Skalenelemente 2, 3 bestehen jeweils aus einem Substrat, welches im dargestellten Ausführungsbeispiel aus Epoxydharz hergestellt ist und auf denen jeweils zwei Teilungsspuren 2.1, 2.2; 3.1, 3.2 angeordnet sind. Die Teilungsspuren 2.1, 2.2; 3.1, 3.2 sind ringförmig ausgebildet und bezüglich der Achse R konzentrisch mit unterschiedlichem Durchmesser auf dem Substrat angeordnet. Die Teilungsspuren 2.1, 2.2; 3.1, 3.2 bestehen jeweils aus einer periodischen Abfolge von alternierend angeordneten elektrisch leitfähigen Teilungsbereichen 2.11, 2.21; 3.11, 3.21 und nichtleitfähigen Teilungsbereichen 2.12, 2.22; 3.12, 3.22. Als Material für die elektrisch leitfähigen Teilbereiche 2.11, 2.21; 3.11, 3.21 wurde im gezeigten Beispiel Kupfer auf das Substrat aufgebracht. In den nichtleitfähigen Teilungsbereichen 2.12, 2.22; 3.12, 3.22 wurde das Substrat dagegen nicht beschichtet. Durch die Anordnung mit jeweils zwei Teilungsspuren 2.1, 2.2; 3.1, 3.2 können die Winkelstellungen der Skalenelemente 2, 3 jeweils absolut bestimmt werden. Die äußerste Teilungsspur 2.2 des ersten Skalenelements 2 weist die größte Anzahl von Teilungsbereichen 2.11, 2.21 entlang einer Umfangslinie auf, so dass durch diese die größte Auflösung bezüglich der Messung der Winkelstellung erzielbar ist.

Im zusammengebauten Zustand gemäß der Figur 1 stehen sich das Abtastelement 1 und die Skalenelemente 2, 3 jeweils mit axialem Abstand beziehungsweise Luftspalt gegenüber, so dass bei einer Relativdrehung zwischen den Skalenelementen 2, 3 und dem Abtastelement 1 in den Empfängerleiterbahnen 1.1121, 1.1141, 1.1221, 1.1241 jeweils ein von der jeweiligen Winkelposition abhängiges Signal durch Induktionseffekte erzeugbar ist. Voraussetzung für die Bildung von entsprechenden Signalen ist, dass die Erregerleiterbahnen 1.1111, 1.1131, 1.1141, 1.1211, 1.1231 ein zeitlich wechselndes elektromagnetisches Erregerfeld im Bereich der jeweilig abgetasteten Teilungsstrukturen erzeugen. Im dargestellten Ausführungsbeispiel sind die Erregerleiterbahnen 1.1111, 1.1131, 1.1141, 1.1211, 1.1231 als mehrere planar-parallele stromdurchflossene Einzel-Leiterbahnen ausgebildet. Das Abtastelement 1 weist eine elektronische Schaltung mit den elektronischen Bauteilen 1.2 auf, die über die Lagen E und F miteinander elektrisch verbunden sind. Die elektronische Schaltung kann beispielsweise auch einen ASIC-Baustein umfassen. Diese elektronische Schaltung des Abtastelements 1 arbeitet nicht nur als Auswerteelement, sondern auch als Erregerkontrollelement, unter dessen Kontrolle der Erregerstrom generiert beziehungsweise erzeugt wird, welcher dann durch die Erregerleiterbahnen 1.1111, 1.1131, 1.1141, 1.1211, 1.1231 fließt. Somit werden die Erregerleiterbahnen 1.1111, 1.1131, 1.1141, 1.1211, 1.1231 durch ein und dasselbe Erregerkontrollelement bestromt. Dabei sind die erste Erregerspur 1.111 und die zweite Erregerspur 1.121 elektrisch in Serie geschaltet.

Werden die Erregerspuren 1.111, 1.121, 1.113, 1.115, 1.121, 1.123 bestromt, so bildet sich um die Erregerleiterbahnen 1.1111, 1.1131, 1.1141, 1.1211, 1.1231 ein schlauch- bzw. zylinderförmig orientiertes elektromagnetisches Feld aus. Die Feldlinien des resultierenden elektromagnetischen Feldes verlaufen um die Erregerspuren 1.111, 1.121, 1.113, 1.115, 1.121, 1.123, wobei die Richtung der Feldlinien in bekannter Art und Weise von der Stromrichtung in den Erregerleiterbahnen 1.1111, 1.1131, 1.1141, 1.1211, 1.1231 abhängt. Im Bereich der leitfähigen Teilbereiche 2.11, 2.21; 3.11, 3.21 werden Wirbelströme induziert, so dass jeweils eine von der Winkelstellung abhängige Modulation des Feldes erreicht wird. Entsprechend kann durch die Empfängerspuren 1.112, 1.114, 1.122, 1.124 jeweils die relative Winkelstellung gemessen werden. Die Paare von Empfängerleiterbahnen 1.1121, 1.1141, 1.1221, 1.1241 sind innerhalb ihrer Empfängerspur 1.112, 1.114, 1.122, 1.124 so angeordnet, dass diese jeweils um 90° phasenversetzte Signale liefern, so dass auch eine Bestimmung der Drehrichtung vorgenommen werden kann. Die Signale, die von den Empfängerspuren 1.112, 1.114, 1.122, 1.124 erzeugt werden, werden mit Hilfe von einigen der elektronischen Bauteile 1.2, die eine Auswerteschaltung bilden, weiterverarbeitet.

Durch die spezielle Dimensionierung und Anordnung der ersten Abschirmschicht 1.13 und der zweiten Abschirmschicht 1.14 kann eine negative Beeinflussung der beiden Detektoreinheiten 1.11, 1.12 im Hinblick auf die Messgenauigkeit weitgehend verhindert werden.

Insbesondere wird ein unzulässig hohes Maß an Übersprechsignalen verhindert aber gleichzeitig eine allzu große Dämpfung der Erregerfelder vermieden. Zudem wird die elektromagnetische Störung der Detektoreinheiten 1.11, 1.12 durch die elektronischen Bauteile 1.2 oder aus externen Quellen unterbunden.

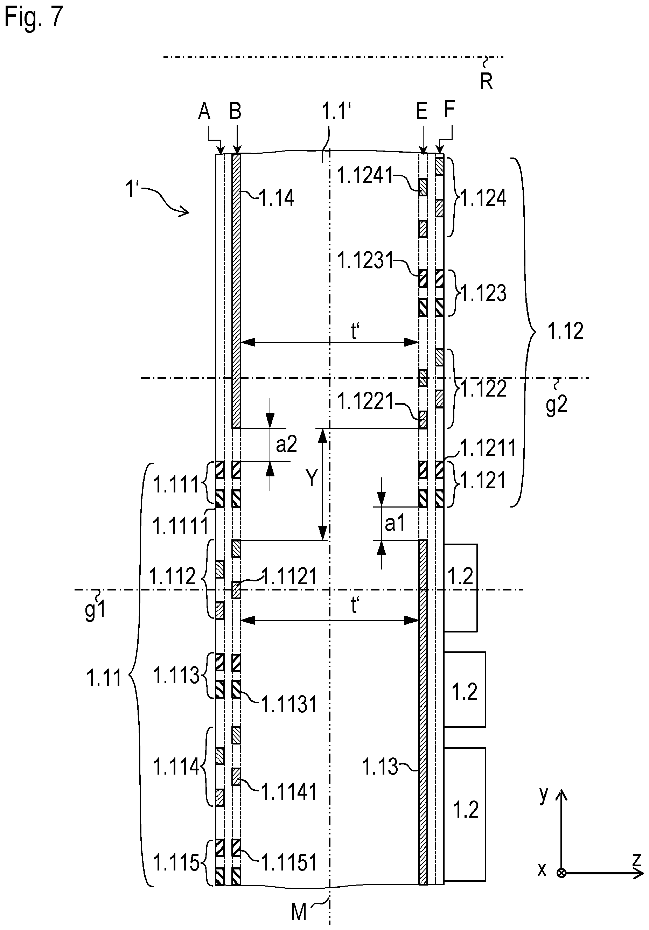

In der Figur 7 ist eine Ausgestaltung eines Abtastelements 1' gemäß einem zweiten Ausführungsbeispiel gezeigt. Die Leiterplatte 1.1' des zweiten Ausführungsbeispiels weist nur vier Lagen A, B, C, D auf. Die erste Abschirmschicht 1.13 befindet sich in diesem Ausführungsbeispiel in der dritten Lage E und die zweite Abschirmschicht 1.14 befindet sich in der zweiten Lage B. Auch hier ist die Distanz t' wesentlich größer als die halbe Dicke der Leiterplatte 1'.

Alternativ könnten auch die erste Abschirmschicht 1.13 in der ersten Lage A und / oder die zweite Abschirmschicht 1.14 in der vierten Lage F angeordnet werden.

## Patentansprüche

1. Abtastelement (1; 1') für eine induktive Positionsmesseinrichtung, das eine mehrlagige Leiterplatte (1.1; 1.1') und elektronische Bauteile (1.2) umfasst, wobei
- die Leiterplatte (1.1; 1.1') eine erste Detektoreinheit (1.11) und eine zweite Detektoreinheit (1.12) umfasst, wobei
- die erste Detektoreinheit (1.11) eine erste Erregerspur (1.111) und eine erste Empfängerspur (1.112) aufweist und
- die zweite Detektoreinheit (1.12) eine zweite Erregerspur (1.121) und eine zweite Empfängerspur (1.122) aufweist, wobei
- die Leiterplatte (1.1; 1.1') eine erste Abschirmschicht (1.13) sowie eine zweite Abschirmschicht (1.14) und eine geometrische Mittenebene (M) aufweist, welche jeweils zwischen den Detektoreinheiten (1.11, 1.12) und zwischen den Abschirmschichten (1.13, 1.14) zu liegen kommt und weiterhin die Leiterplatte (1.1; 1.1') so aufgebaut ist, dass
- in einer ersten Lage (A) und in einer zweiten Lage (B) die erste Detektoreinheit (1.11) angeordnet ist,
- in einer dritten Lage (E) und in einer vierten Lage (F) die zweite Detektoreinheit (1.12) angeordnet ist, und die Abschirmschichten (1.13, 1.14) so dimensioniert sind, dass
- eine erste Gerade (g1) sowohl die erste Detektoreinheit (1.11) als auch die erste Abschirmschicht (1.13) durchdringt, während die zweite Abschirmschicht (1.14) nicht von der ersten Geraden (g1) durchdrungen wird, wobei ausgehend von der ersten Detektoreinheit (1.11) die erste Abschirmschicht (1.13) jenseits der Mittenebene (M) angeordnet ist,
- eine zweite Gerade (g2) sowohl die zweite Detektoreinheit (1.12) als auch die zweite Abschirmschicht (1.14) durchdringt, während die erste Abschirmschicht (1.13) nicht von der zweiten Geraden (g2) durchdrungen wird, wobei ausgehend von der zweiten Detektoreinheit (1.12) die zweite Abschirmschicht (1.14) jenseits der Mittenebene (M) angeordnet ist, wobei
die erste Gerade (g1) und die zweite Gerade (g2) orthogonal zur Mittenebene (M) orientiert sind.

2. Abtastelement (1) gemäß dem Anspruch 1, wobei die erste Abschirmschicht (1.13) in einer fünften Lage (C) und die zweite Abschirmschicht (1.14) in einer sechsten Lage (D) angeordnet sind.

3. Abtastelement (1') gemäß dem Anspruch 1, wobei die erste Abschirmschicht (1.13) in der ersten Lage (A) oder in der zweiten Lage (B) und die zweite Abschirmschicht (1.14) in der dritten Lage (E) oder in der vierten Lage (F) angeordnet sind.

4. Abtastelement (1; 1') gemäß einem der vorhergehenden Ansprüche, wobei die erste Erregerspur (1.111) und die zweite Erregerspur (1.121) entlang einer ersten Richtung (x) verlaufen und in einer zweiten Richtung (y), die orthogonal zur ersten Richtung (x) orientiert ist, ist
- die erste Abschirmschicht (1.13) mit einem ersten Abstand (a1) versetzt gegenüber der zweiten Erregerspur (1.121) angeordnet und / oder
- die zweite Abschirmschicht (1.14) mit einem zweiten Abstand (a2) versetzt gegenüber der ersten Erregerspur (1.111) angeordnet.

5. Abtastelement (1; 1') gemäß dem Anspruch 4, wobei in einer dritten Richtung (z) orthogonal zur Mittenebene
- die erste Detektoreinheit (1.11) mit einer Distanz (t; t') versetzt gegenüber der ersten Abschirmschicht (1.13) angeordnet ist, wobei der zweite Abstand (a2) größer oder gleich 25% der Distanz (t; t') und kleiner oder gleich 100% der Distanz (t; t') ist, so dass gilt
0,25·t ≤ a2 ≤ 1·t beziehungsweise 0,25·t' ≤ a2 ≤ 1·t' und / oder
- die zweite Detektoreinheit (1.12) mit einer Distanz (t; t') versetzt gegenüber der zweiten Abschirmschicht (1.14) angeordnet ist, wobei der erste Abstand (a1) größer oder gleich 25% der Distanz (t; t') und kleiner oder gleich 100% der Distanz (t; t') ist, so dass gilt
0,25 t ≤ a1 ≤ 1·t beziehungsweise 0,25·t' ≤ a1 ≤ 1·t'.

6. Abtastelement (1; 1') gemäß einem der vorhergehenden Ansprüche, wobei die erste Empfängerspur (1.112) und die zweite Empfängerspur (1.122) entlang einer ersten Richtung (x) verlaufen und die erste Empfängerspur (1.112) in einer zweiten Richtung (y) mit einem Versatz (Y) gegenüber der zweiten Empfängerspur (1.122) angeordnet ist.

7. Abtastelement (1; 1') gemäß einem der vorhergehenden Ansprüche, wobei das Abtastelement (1; 1') so ausgestaltet ist, dass die erste Gerade (g1) und / oder die zweite Gerade (g2) eines der elektronischen Bauteile (1.2) durchdringt.

8. Abtastelement (1; 1') gemäß einem der vorhergehenden Ansprüche, wobei die Leiterplatte (1.1; 1.1') so aufgebaut ist, dass die erste Gerade (g1) die erste Empfängerspur (1.112) und / oder die zweite Gerade (g2) die zweite Empfängerspur (1.122) durchdringt.

9. Abtastelement (1; 1') gemäß einem der vorhergehenden Ansprüche, wobei die erste Erregerspur (1.111) und die zweite Erregerspur (1.121) entlang einer ersten Richtung (x) verlaufen und die erste Erregerspur (1.111) relativ zur zweiten Erregerspur (1.121) auf der Leiterplatte (1.1; 1.1')bezogen auf die zweite Richtung (y) überlappend angeordnet ist.

10. Abtastelement (1; 1') gemäß einem der vorhergehenden Ansprüche, wobei die erste Detektoreinheit (1.11) eine dritte Erregerspur (1.113) und die zweite Detektoreinheit (1.12) eine vierte Erregerspur (1.123) aufweist.

11. Abtastelement (1; 1') gemäß einem der vorhergehenden Ansprüche, wobei das Abtastelement (1; 1') so ausgestaltet ist, dass die erste Erregerspur (1.111) und die zweite Erregerspur (1.121) elektrisch in Serie geschaltet sind.

12. Abtastelement (1; 1') gemäß einem der vorhergehenden Ansprüche, wobei die erste Erregerspur (1.111) und die zweite Erregerspur (1.121) mit einem zeitlich wechselnden Erregerstrom bestrombar sind, wobei der Erregerstrom mit Hilfe der elektronischen Bauteile (1.2) generierbar ist.

13. Abtastelement (1; 1') gemäß einem der vorhergehenden Ansprüche, wobei Signale, die von der ersten Empfängerspur (1.112) und der zweiten Empfängerspur (1.122) erzeugbar sind, mit Hilfe der elektronischen Bauteile (1.2) weiterverarbeitbar sind.

14. Induktive Positionsmesseinrichtung umfassend ein Abtastelement (1; 1') gemäß einem der vorhergehenden Ansprüche sowie einem ersten Skalenelement (2) und einem zweiten Skalenelement (3), wobei die Skalenelemente (2, 3) in einer dritten Richtung (z), die orthogonal zur Mittenebene orientiert ist, beabstandet beidseits der Leiterplatte (1.11, 1.11') angeordnet sind.

15. Induktive Positionsmesseinrichtung gemäß dem Anspruch 14, wobei die Skalenelemente (2, 3) um eine gemeinsame Achse (R) relativ zum Abtastelement (1; 1') drehbar angeordnet sind.

## Claims

1. Scanning element (1; 1') for an inductive position measurement device, comprising a multilayer circuit board (1.1; 1.1') and electronic components (1.2), wherein
- the circuit board (1.1; 1.1') comprises a first detector unit (1.11) and a second detector unit (1.12), wherein
- the first detector unit (1.11) has a first exciter track (1.111) and a first receiver track (1.112) and
- the second detector unit (1.12) has a second exciter track (1.121) and a second receiver track (1.122), wherein
- the circuit board (1.1; 1.1') has a first shielding layer (1.13) and a second shielding layer (1.14) and a geometric middle plane (M) which comes to rest in each case between the detector units (1.11, 1.12) and between the shielding layers (1.13, 1.14) and furthermore the circuit board (1.1; 1.1') is configured such that
- the first detector unit (1.11) is arranged at a first layer (A) and at a second layer (B),
- the second detector unit (1.12) is arranged at a third layer (E) and at a fourth layer (F), and the shielding layers (1.13, 1.14) are dimensioned such that
- a first straight line (g1) intersects both the first detector unit (1.11) and the first shielding layer (1.13), while the second shielding layer (1.14) is not intersected by the first straight line (g1), wherein, starting from the first detector unit (1.11), the first shielding layer (1.13) is arranged away from the middle plane (M),
- a second straight line (g2) intersects both the second detector unit (1.12) and the second shielding layer (1.14), while the first shielding layer (1.13) is not intersected by the second straight line (g2), wherein, starting from the second detector unit (1.12), the second shielding layer (1.14) is arranged away from the middle plane (M), wherein the first straight line (g1) and the second straight line (g2) are oriented orthogonally to the middle plane (M).

2. Scanning element (1) according to Claim 1, wherein the first shielding layer (1.13) is arranged at a fifth layer (C) and the second shielding layer (1.14) is arranged at a sixth layer (D).

3. Scanning element (1') according to Claim 1, wherein the first shielding layer (1.13) is arranged at the first layer (A) or at the second layer (B) and the second shielding layer (1.14) is arranged at the third layer (E) or at the fourth layer (F).

4. Scanning element (1; 1') according to any of the preceding claims, wherein the first exciter track (1.111) and the second exciter track (1.121) run along a first direction (x) and, in a second direction (y) which is oriented orthogonally to the first direction (x),
- the first shielding layer (1.13) is arranged offset with respect to the second exciter track (1.121) by a first distance (a1) and/or
- the second shielding layer (1.14) is arranged offset with respect to the first exciter track (1.111) by a second distance (a2).

5. Scanning element (1; 1') according to Claim 4, wherein, in a third direction (z) orthogonally to the middle plane,
- the first detector unit (1.11) is arranged offset with respect to the first shielding layer (1.13) by a distance (t; t'), wherein the second distance (a2) is greater than or equal to 25% of the distance (t; t') and smaller than or equal to 100% of the distance (t, t'], so that
0.25·t ≤ a2 ≤ 1·t and 0.25-t' ≤ a2 ≤ 1·t'
and/or
- the second detector unit (1.12) is arranged offset with respect to the second shielding layer (1.14) by a distance (t; t'), wherein the first distance (a1) is greater than or equal to 25% of the distance (t; t') and smaller than or equal to 100% of the distance (t; t'), so that
0.25·t ≤ a1 ≤ 1·t and 0.25·t' ≤ a1 ≤ 1·t'.

6. Scanning element (1; 1') according to any of the preceding claims, wherein the first receiver track (1.112) and the second receiver track (1.122) run along a first direction (x) and the first receiver track (1.112) is arranged with an offset (Y) with respect to the second receiver track (1.122) in a second direction (y).

7. Scanning element (1; 1') according to any of the preceding claims, wherein the scanning element (1; 1') is configured such that the first straight line (g1) and/or the second straight line (g2) intersects one of the electronic components (1.2).

8. Scanning element (1; 1') according to any of the preceding claims, wherein the circuit board (1.1; 1.1') is configured such that the first straight line (g1) intersects the first receiver track (1.112) and/or the second straight line (g2) intersects the second receiver track (1.122).

9. Scanning element (1; 1') according to any of the preceding claims, wherein the first exciter track (1.111) and the second exciter track (1.121) run along a first direction (x) and the first exciter track (1.111) is arranged with an overlap relative to the second exciter track (1.121) on the circuit board (1.1; 1.1') with respect to the second direction (y).

10. Scanning element (1; 1') according to any of the preceding claims, wherein the first detector unit (1.11) has a third exciter track (1.113) and the second detector unit (1.12) has a fourth exciter track (1.123).

11. Scanning element (1; 1') according to any of the preceding claims, wherein the scanning element (1; 1') is configured such that the first exciter track (1.111) and the second exciter track (1.121) are electrically connected in series.

12. Scanning element (1; 1') according to any of the preceding claims, wherein the first exciter track (1.111) and the second exciter track (1.121) are able to be supplied with temporally alternating field current, wherein the field current is able to be generated with the aid of the electronic components (1.2).

13. Scanning element (1; 1') according to any of the preceding claims, wherein signals that are able to be generated by the first receiver track (1.112) and the second receiver track (1.122) are able to be processed further with the aid of the electronic components (1.2).

14. Inductive position measurement device comprising a scanning element (1; 1') according to any of the preceding claims and a first scale element (2) and a second scale element (3), wherein the scale elements (2, 3) are arranged in a third direction (z), which is oriented orthogonally to the middle plane, at a distance on both sides of the circuit board (1.11, 1.11').

15. Inductive position measurement device according to Claim 14, wherein the scale elements (2, 3) are arranged rotatably about a common axis (R) relative to the scanning element (1; 1').

## Revendications

1. Élément de balayage (1 ; 1') destiné à un dispositif inductif de mesure de position qui comprend une carte de circuit imprimé multicouche (1.1 ; 1.1') et des composants électroniques (1.2),
- la carte de circuit imprimé (1.1 ; 1.1') comprenant une première unité de détection (1.11) et une deuxième unité de détection (1.12),
- la première unité de détection (1.11) comportant une première piste d'excitation (1.111) et une première piste de réception (1.112) et
- la deuxième unité de détection (1.12) comportant une deuxième piste d'excitation (1.121) et une deuxième piste de réception (1.122),
- la carte de circuit imprimé (1.1 ; 1.1') comportant une première couche de blindage (1.13) et une deuxième couche de blindage (1.14) et un plan médian géométrique (M) qui vient se situer à chaque fois entre les unités de détection (1.11, 1.12) et entre les couches de blindage (1.13, 1.14) et en outre la carte de circuit imprimé (1.1 ; 1.1') étant construite de manière à ce que
- la première unité de détection (1.11) soit disposée dans une première strate (A) et dans une deuxième strate (B),
- la deuxième unité de détection (1.12) soit disposée dans une troisième strate (E) et une quatrième strate (F), et les couches de blindage (1.13, 1.14) étant dimensionnées de manière à ce que
- une première droite (g1) traverse aussi bien la première unité de détection (1.11) que la première couche de blindage (1.13), tandis que la deuxième couche de blindage (1.14) n'est pas traversée par la première droite (g1), la première couche de blindage (1.13) étant disposée, à partir de la première unité de détection (1.11), au-delà du plan médian (M),
- une deuxième droite (g2) traverse aussi bien la deuxième unité de détection (1.12) que la deuxième couche de blindage (1.14), tandis que la première couche de blindage (1.13) n'est pas traversée par la deuxième droite (g2), la deuxième couche de blindage (1.14) étant disposée, à partir de la deuxième unité de détection (1.12), au-delà du plan médian (M), la première droite (g1) et la deuxième droite (g2) étant orientées orthogonalement au plan médian (M).

2. Élément de balayage (1) selon la revendication 1, la première couche de blindage (1.13) étant disposée dans une cinquième strate (C) et la deuxième couche de blindage (1.14) étant disposée dans une sixième strate (D) .

3. Élément de balayage (1') selon la revendication 1, la première couche de blindage (1.13) étant disposée dans la première strate (A) ou dans la deuxième strate (B) et la deuxième couche de blindage (1.14) étant disposée dans la troisième strate (E) ou dans la quatrième strate (F).

4. Élément de balayage (1 ; 1') selon l'une des revendications précédentes, la première piste d'excitation (1.111) et la deuxième piste d'excitation (1.121) s'étendant suivant une première direction (x) et, dans une deuxième direction (y) qui est orientée orthogonalement à la première direction (x),
- la première couche de blindage (1.13) étant disposée de manière décalée d'un premier espacement (a1) par rapport à la deuxième piste d'excitation (1.121) et/ou
- la deuxième couche de blindage (1.14) étant disposée de manière décalée d'un deuxième espacement (a2) par rapport à la première piste d'excitation (1.111).

5. Élément de balayage (1 ; 1') selon la revendication 4, dans une troisième direction (z) orthogonale au plan médian
- la première unité de détection (1.11) étant disposée de manière décalée d'une distance (t ; t') par rapport à la première couche de blindage (1.13), le deuxième espacement (a2) étant supérieur ou égal à 25 % de la distance (t ; t') et inférieur ou égal à 100 % de la distance (t ; t'), de sorte que
0,25·t ≤ a2 ≤ 1·t ou 0,25-t' ≤ a2 ≤ 1·t' et/ou
- la deuxième unité de détection (1.12) étant disposée de manière décalée d'une distance (t ; t') par rapport à la deuxième couche de blindage (1.14), le premier espacement (a1) étant supérieur ou égal à 25 % de la distance (t ; t') et inférieur ou égal à 100 % de la distance (t ; t') de sorte que
0,25·t ≤ a1 ≤ 1·t ou 0,25-t' ≤ a1 ≤ 1·t'

6. Élément de balayage (1 ; 1') selon l'une des revendications précédentes, la première piste de réception (1.112) et la deuxième piste de réception (1.122) s'étendant suivant une première direction (x) et la première piste de réception (1.112) étant disposée dans une deuxième direction (y) avec un décalage (Y) par rapport à la deuxième piste de réception (1.122).

7. Élément de balayage (1 ; 1') selon l'une des revendications précédentes, l'élément de balayage (1 ; 1') étant conçu de sorte que la première droite (g1) et/ou la deuxième droite (g2) traversent l'un des composants électroniques (1.2).

8. Élément de balayage (1 ; 1') selon l'une des revendications précédentes, la carte de circuit imprimé (1.1 ; 1.1') étant construite de sorte que la première droite (g1) traverse la première piste de réception (1.112) et/ou la deuxième droite (g2) traverse la deuxième piste de réception (1.122).

9. Élément de balayage (1 ; 1') selon l'une des revendications précédentes, la première piste d'excitation (1.111) et la deuxième piste d'excitation (1.121) s'étendant suivant une première direction (x) et la première piste d'excitation (1.111) étant disposée, relativement à la deuxième piste d'excitation (1.121) sur la carte de circuit (1.1 ; 1.1'), à chevauchement par rapport à la deuxième direction (y).

10. Élément de balayage (1 ; 1') selon l'une des revendications précédentes, la première unité de détection (1.11) comportant une troisième piste d'excitation (1.113) et la deuxième unité de détection (1.12) comportant une quatrième piste d'excitation (1.123).

11. Élément de balayage (1 ; 1') selon l'une des revendications précédentes, l'élément de balayage (1 ; 1') étant conçu de manière à ce que la première piste d'excitation (1.111) et la deuxième piste d'excitation (1.121) soient montées électriquement en série.

12. Élément de balayage (1 ; 1') selon l'une des revendications précédentes, la première piste d'excitation (1.111) et la deuxième piste d'excitation (1.121) pouvant être alimentées avec un courant d'excitation qui varie dans le temps, le courant d'excitation pouvant être généré à l'aide des composants électroniques (1.2).

13. Élément de balayage (1 ; 1') selon l'une des revendications précédentes, les signaux qui peuvent être générés par la première piste de réception (1.112) et la deuxième piste de réception (1.122) pouvant être traités ultérieurement à l'aide des composants électroniques (1.2).

14. Dispositif inductif de mesure de position comprenant un élément de balayage (1 ; 1') selon l'une des revendications précédentes ainsi qu'un premier élément d'échelle (2) et un deuxième élément d'échelle (3), les éléments d'échelle (2, 3) étant disposés dans une troisième direction (z), qui est orientée orthogonalement au plan médian, à distance l'un de l'autre des deux côtés de la carte de circuit imprimé (1.11, 1.11').

15. Dispositif inductif de mesure de position selon la revendication 14, les éléments d'échelle (2, 3) étant disposés de manière à pouvoir tourner sur un axe commun (R) par rapport à l'élément de balayage (1 ; 1').
